# EUROPEAN PATENT APPLICATION

(11) **EP 0 621 629 A2**
(43) Date of publication of application: **26.10.1994**
(21) Application number: 94105613.7
(22) Date of filing: 12.04.1994
(51) Int. Cl.: H01L 21/265, H01L 21/336, H01L 21/82, H01L 29/08

(54) **Method for reducing dislocations in integrated circuit devices**

(71) Applicant: TEXAS INSTRUMENTS INCORPORATED, Dallas Texas 75265 (US)
(72) Inventor: Guldi, Richard L., Dallas, TX 75248 (US)
(74) Representative: Schwepfinger, Karl-Heinz, Dipl.-Ing.

(57) **Abstract**

A method for fabricating an integrated circuit device in a semiconductor layer (2) of a first conductivity type includes forming a screen insulating layer (17) over the semiconductor layer (2) and implanting an impurity through the screen insulating layer (17) into the semiconductor layer (2) to form an implanted region (18). The screen insulating layer (17) is then removed and the implanted region (18) annealed. The annealing of the implanted region (18) after removal of the screen insulating layer (17) results in a reduction of residual recrystallization damage in the implanted region (18) and, as a result, a reduction in dislocation density in the integrated circuit device. The reduction in dislocation density translates into an increase in manufacturing yield and an increase in reliability.

## Description

### FIELD OF THE INVENTION

This invention relates generally to semiconductor devices and, more particularly, to a method for reducing dislocations in integrated circuit devices by minimizing recrystallization damage.

### BACKGROUND OF THE INVENTION

A problem in the manufacture of integrated circuits is the formation of certain defects, commonly referred to as dislocations. There are various types of dislocations, but in general, all manifestations are some form of distortion of the crystalline lattice. Dislocations have undesired effects on device yield and reliability, because they can provide conductive paths that short out electrical signals.

One source of dislocations arises when a semiconductor material is implanted with a high dose implant which creates structural damage in the crystalline semiconductor material or even makes the surface region of the semiconductor material amorphous. When the damaged region is annealed, microscopic dislocations form. If the semiconductor material becomes amorphous during implant, it recrystallizes into crystalline material during annealing, but some degree of imperfect recrystallization occurs due to spatially non-uniform recrystallization regrowth rates. In this case, microscopic dislocations are a manifestation of this imperfect recrystallization.

These microscopic dislocations can propagate into longer dislocations under the influence of stress from subsequent device manufacturing steps and can then become extended dislocations, traversing distances on the order of microns.

One type of dislocation, as identified by existing defect analysis, is a gate edge dislocation, which is a line that penetrates into a gate region under a sidewall spacer. Various techniques have been suggested to prevent this type of dislocation. These techniques include fabricating spacers with less steep sidewalls and using disposable spacers. However, these techniques pose considerable difficulties for manufacturing processes. For example, disposable spacers cannot be economically used to manufacture salicided circuits because the spacer which is removed before source/drain anneal must be redeposited after anneal and before silicide reaction to prevent gate to active region shorts. Similarly, there is no currently available procedure for reducing sidewall spacer slope while controlling sub-micron geometries.

Other defect studies have focussed on the relationship between implantation techniques and the formation of dislocations. Several studies have recognized a relationship between dislocations and implanted regions that become amorphized. A pre-amorphization process has been suggested to prevent these dislocations.

A problem with existing studies is that they have been unsuccessful in determining a general and practical solution for reducing dislocations. Existing preventative measures are either directed to a particular type of dislocation or require numerous additional process steps. For example, the disposable spacer technique addresses dislocation formation at the edge of a transistor gate, but not at the edge of field oxide.

A need exists for a method of reducing extended dislocations that applies to all types of dislocations and is easily implemented.

### BRIEF DESCRIPTION OF THE DRAWINGS

In the drawings:
Figures 1-5 are cross-sectional elevation views of a field effect transistor at successive stages during fabrication according to the prior art; and
Figures 6-7 are cross-sectional elevation views of a field effect transistor at successive stages during fabrication according to the invention.

Corresponding numerals and symbols in the different figures refer to corresponding parts unless otherwise indicated.

### DETAILED DESCRIPTION OF PREFERRED EMBODIMENTS

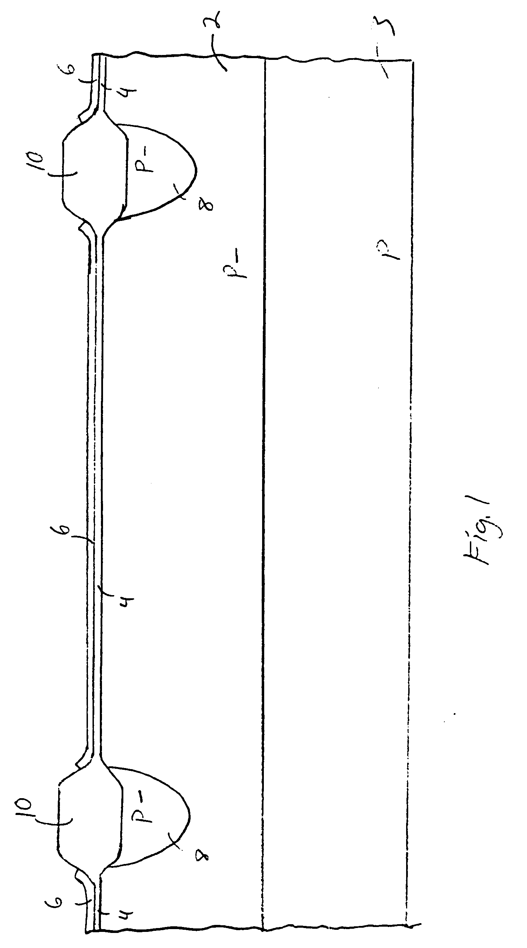

Successive stages in a method of fabricating a field effect transistor according to the prior art are shown in cross-sectional elevation views in Figures 1-5, which represent the p-well of a CMOS integrated circuit in which n-channel transistors are fabricated. As seen in Figure 1, a layer 2 of p- type epitaxial silicon is initially formed on a p-type substrate 3. An oxide layer 4 is grown or deposited on the face of layer 2 to a depth of about 40 nanometers. A silicon nitride layer 6 is then deposited over layer 4 using low pressure chemical vapor deposition.

Layers 4 and 6 are then patterned with photoresist and plasma etched to define the active region in layer 2 in which the field effect transistor will be formed. As a result of the patterning and etching step of layers 4 and 6, oxide/nitride layers 4 and 6 remain over the active region in layer 2. The areas in layer 2 where isolating thick field oxide will be subsequently be formed are exposed.

A boron implant is then performed to create p- channel stop regions 8. The photoresist is then removed and thick field oxide regions 10 are thermally grown to a thickness of about 600-1000 nanometers. The remaining portions of layers 4 and 6 are then removed by etching to expose the face of layer 2.

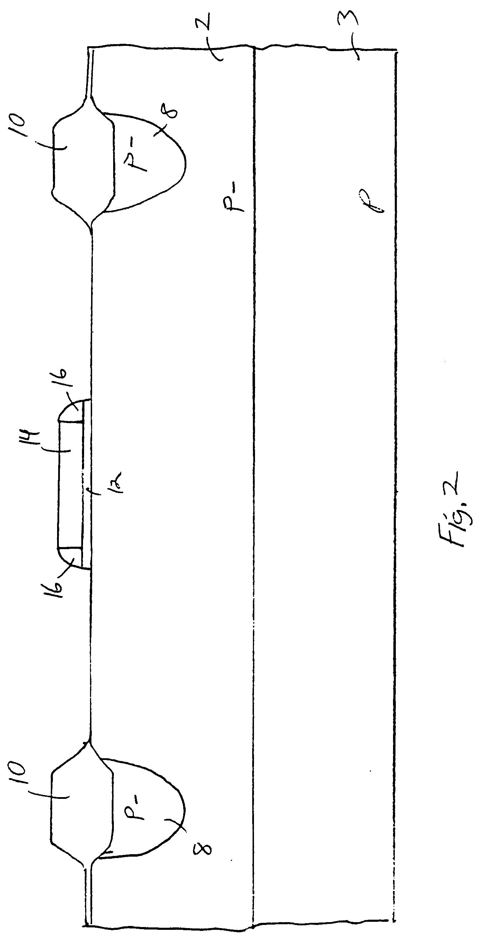

A gate oxide 12 is then thermally grown over the face of layer 2 between field oxide regions 10 to a thickness of about 10-40 nanometers. A layer of polysilicon is then deposited over layer 2 and doped N+ with an impurity such as phosphorous to render it conductive. The layer of polysilicon is then patterned with photoresist. A plasma etch removes the unprotected portion of the polysilicon layer to define conductive gate 14. An oxide layer is then deposited over layer 2 and anisotropically etched to form sidewall spacers 16. This etch also removes a portion of gate oxide 12 to expose the face of layer 2 between field oxide regions 10 and gate 14 as seen in Figure 2.

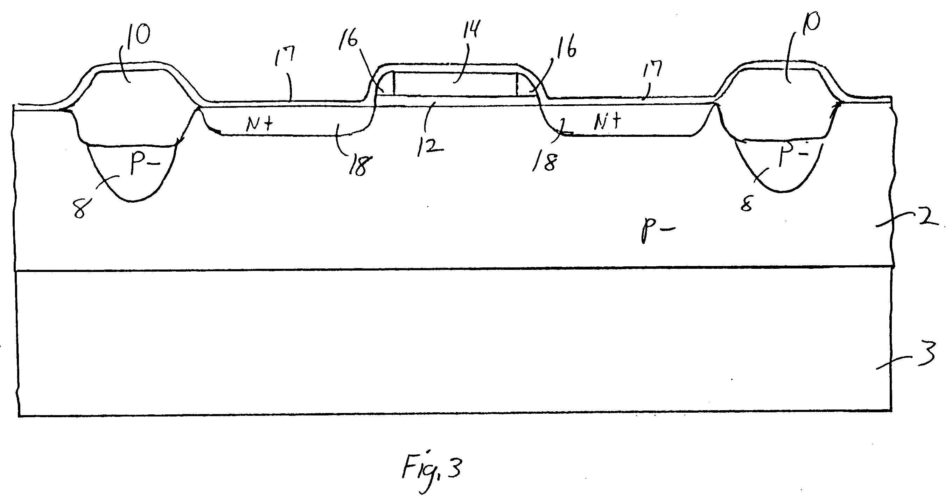

As seen in Figure 3, a screen insulating layer 17 formed of oxide, nitride, or oxy-nitride, for example, and having a thickness of about 20-40 nanometers is then deposited or grown over layer 2. Screen insulating layer 17 prevents undesirable species, such as metal impurities, from reaching silicon layer 2 during source/drain implantation. The undesirable species have a lower energy than the species to be implanted during source/drain implantation and do not penetrate through screen insulating layer 17.

Source/drain implants of a donor impurity, such as arsenic, phosphorous, or antimony, are then performed using sidewall spacers 16 and gate 14 as a mask to create implanted source/drain regions 18. The source/drain implantation heavily damages the silicon in source/drain regions 18 and in many cases causes the silicon to be amorphized.

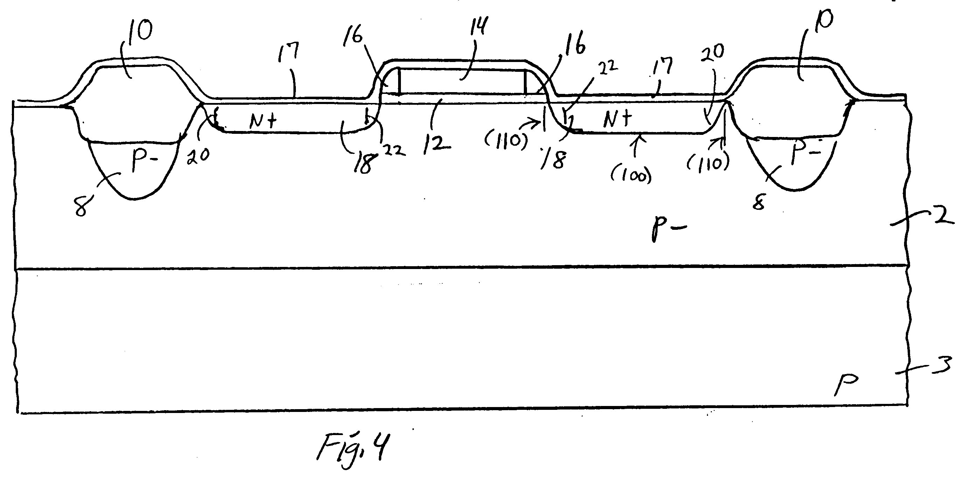

An anneal is subsequently performed in either a furnace tube or in a single wafer rapid thermal annealer to electrically activate the source/drain impurity. During the anneal, the silicon damaged by implantation undergoes recrystallization. The recrystallization rate depends on crystallographic direction and proceeds fastest for (100) and (110) planes. These planes are often aligned along the edge of an implanted region for typical integrated circuit layouts. Figure 4 shows the (100) and (110) planes aligned along the edges of implanted source/drain regions 18.

As recrystallization proceeds, beginning first at the boundaries between amorphous and recrystallized silicon at the bottom and sides of implanted regions 18, an area along the intersection of the fast growing (100) and (110) planes undergoes imperfect recrystallization. As a result of the imperfect recrystallization, residual damage in the form of dislocations 20 adjacent field oxide regions 10 and dislocations 22 adjacent gate 14 can occur. Dislocations 20 and 22 may propagate into extend dislocations by the application of stress from overlayers or by subsequent processing.

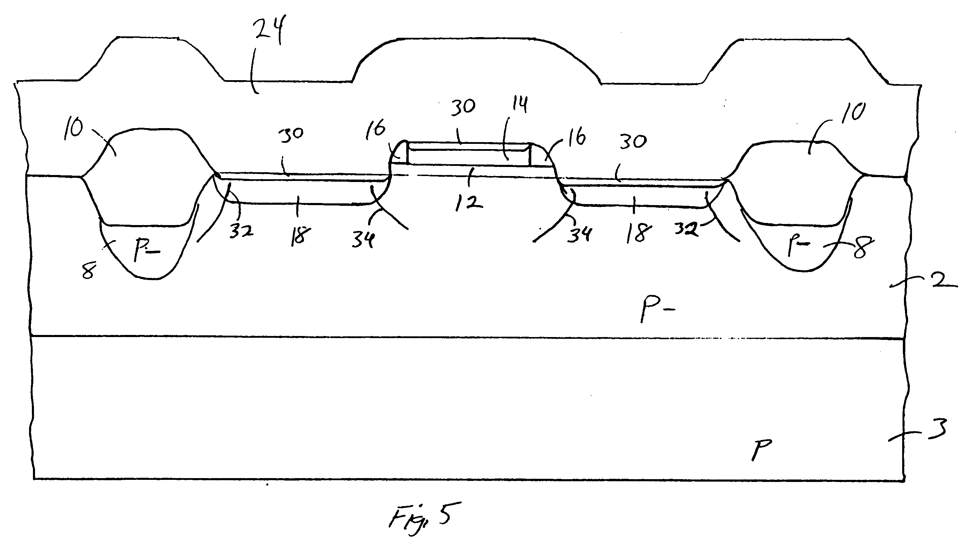

After source/drain anneal, screen insulating layer 17 may be left intact to become part of the final device structure or it may be removed by an etch prior to the formation of silicide layers 30 over source/drain regions 18 as shown in Figure 5. Silicide layers 30 are formed by depositing a thin film of material such as Ti or Co, on the surface of layer 2 and reacting that material to form silicide layers 30 over source/drain regions 18 and gate 14.

A poly-metal dielectric deposition (PMD) layer 24 is then deposited on layer 2, as shown in Figure 5, to provide insulation between gate 14 and source/drain regions 18 and a subsequently applied metal layer (not shown). Fabrication of PMD layer 24 involves high stress and high temperature and is an example of a processing step that can cause incipient damage areas, such as dislocations 20 and 22, to propagate into extended dislocations. Conventionally, PMD layer 24 is formed by low pressure chemical vapor deposition (LPCVD) at temperatures as high as 700 degrees Centigrade. The fabrication of PMD layer 24 by conventional LPCVD techniques produces high stress in layer 2 especially at gate edges and field oxide edges. The high stress at gate and field oxide edges can cause dislocations 20 and 22 to propagate into extended dislocations 32 and 34 as shown in Figure 5. Extended dislocations 32 and 34 may traverse distances as long as several microns.

Extended dislocations 32 and 34 may become electrically active to provide a path for undesirable leakage currents that can render a circuit defective. Extended dislocations that become electrically active during manufacturing and testing are therefore a cause of yield loss. Extended dislocations that become electrically active in use subsequent to testing cause concern with regard to device reliability.

The fabrication of a field effect transistor according to the method of the invention will now be described. Initially, the same steps discussed with respect to Figures 1-3 are performed to produce the structure of Figure 3. In contrast to the prior art method described above, the screen insulating layer 17 is then removed by either a wet chemical or plasma etch to expose the surface of source/drain regions 18 as shown in Figure 5. The removal step is performed after the source/drain implants but before the source/drain anneal.

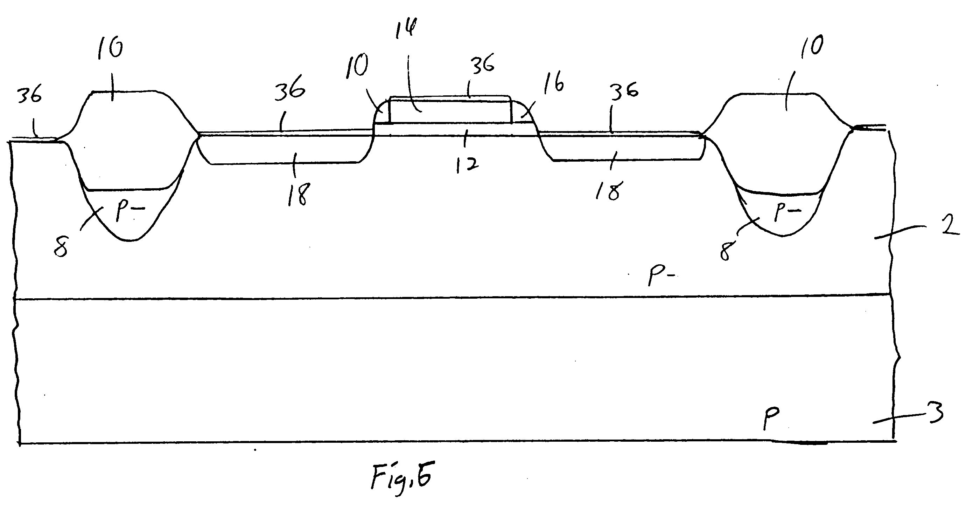

As seen in Figure 6, a thin native oxide (SiO₂) layer 36 approximately 1-2 nanometers thick then grows on the exposed surfaces of source/drain regions 18 by exposure to air. This oxide layer 36 may grow in thickness to up to 4 nanometers thick during subsequent conventional chemical treatments, such as those used to remove particulate contamination. A source/drain anneal is then performed in a non-oxidizing atmosphere, such as nitrogen. In a suitable annealing process using nitrogen, the structure of Figure 6 is placed in a furnace chamber having a nitrogen ambient at between 450-700 degrees Centigrade for 30-120 minutes. The temperature is then ramped up to 900 degrees Centigrade at a rate of about 10 degrees Centigrade per minute in a nitrogen ambient. When the temperature reaches 900 degrees Centigrade during ramp up, the furnace is held at 900 degrees Centigrade in nitrogen for 20-60 minutes. The temperature is then ramped down to 800 degrees Centigrade at a rate of about 3 degrees Centigrade per minute in a nitrogen atmosphere. When the temperature reaches 800 degrees Centigrade the structure of Figure 6 is removed from the furnace. The anneal process may use other annealing schedules and may also take place in non-oxidizing atmospheres other than nitrogen, such as argon or vacuum. Rapid thermal annealing may also be used instead of furnace annealing.

During the anneal process, the vapor pressure of SiO causes the volatilization of SiO gas from the surface of native oxide layer 36 causing layer 36 to become silicon deficient. The subsequent tendency for silicon in source/drain regions 18 at the silicon-silicon dioxide interface between source/drain regions 18 and layer 36 to react with the oxygen-rich silicon dioxide in layer 36 provides a driving force to increase the concentration of silicon lattice vacancies in implanted source/drain regions 18. These silicon lattice vacancies are then able to diffuse into implant-damaged areas in source/drain regions 18 to counteract implant recrystallization damage. As a result of performing the anneal after removal of screen insulating layer 17 there is a substantial reduction in the likelihood that dislocations, such as dislocations 20 and 22 in Figure 4, will occur.

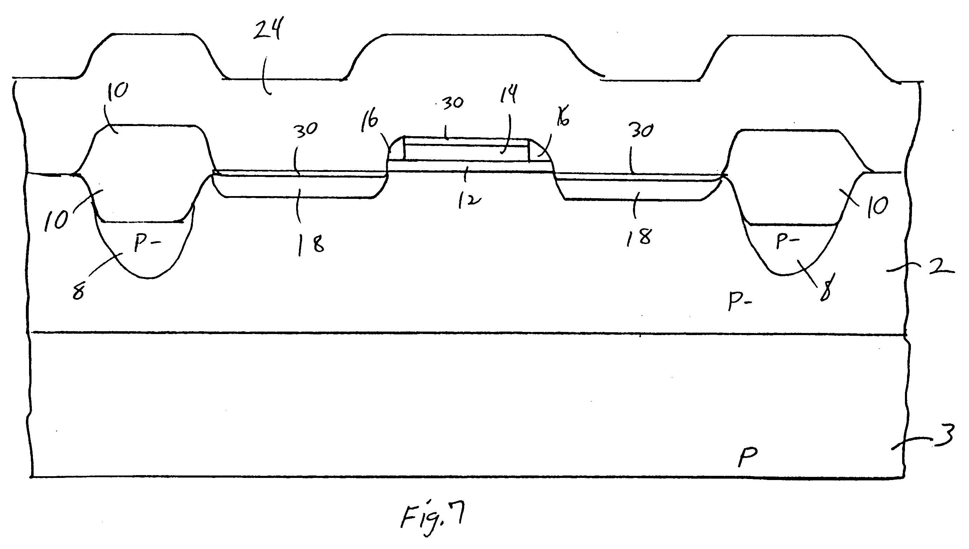

A thin film of material, such as Ti or Co, is then deposited on the surface of layer 2 and reacted to form silicide layers 30 over source/drain regions 18 and gate 14. A poly-metal dielectric deposition (PMD) layer 24 is then deposited on layer 2, as shown in Figure 7, to provide insulation between gate 14 and source/drain regions 18 and a subsequently applied metal layer (not shown). Since residual implant recrystallization damage during anneal is substantially reduced by the diffusion of silicon lattice vacancies into damaged areas, the likelihood that extended dislocations, such as extended dislocations 32 and 34 of Figure 5, will occur as a result of the stress introduced by layer 24 or other subsequent processing is also substantially reduced.

Experimental results obtained in a study using p- epitaxial layers and oxide screen insulating layers demonstrate the benefits of annealing implanted silicon with the screen insulating layer removed. This study used twin-well CMOS devices with source/drain regions formed by implanting 1-3E15 arsenic atoms/cm² at 120-150 KeV and 4E14 phosphorous atoms/cm² at 100 KeV into p-well regions and 1-3E15 boron atoms per cm² at 10-35 KeV into n-wells. The study also used the furnace annealing process described above with respect to Figure 6. Dislocation densities in source/drain regions in the p-wells at the edge of field oxide were determined for devices fabricated according to the invention and for devices fabricated according to the prior art method described in Figures 1-5. The dislocation density resulting from using the process of the invention was half that resulting from using the prior art method.

An advantage of the invention is the reduction of residual recrystallization damage during anneal of implanted silicon and, as a result, a reduction in dislocation density. The reduction in dislocation density translates into an increase in manufacturing yield and an increase in reliability.

A few preferred embodiment has been described in detail hereinabove. It is to be understood that the scope of the invention also comprehends embodiments different from those described, yet within the scope of the claims.

For example, the method can be used to fabricate an FET directly in the face of a substrate instead of in the face of an epitaxial layer or when fabricating an FET of the opposite conductivity type as in the case of a p-channel transistor of a CMOS integrated circuit. In addition, although described in terms of FET manufacture, the process of the invention can be applied to any process that forms implanted regions in a semiconductor layer through a screen insulating layer, such as emitter/collector contact formation in bipolar transistor fabrication or buried bitline formation in memory device fabrication. The process is also applicable to semiconductor materials other than silicon in which an implanted region is damaged by the implant.

While this invention has been described with reference to an illustrative embodiment, this description is not intended to be construed in a limiting sense. Various modifications and combinations of the illustrative embodiment, as well as other embodiments of the invention, will be apparent to persons skilled in the art upon reference to the description. It is therefore intended that the appended claims encompass any such modifications or embodiments.

## Claims

1. A method for fabricating an integrated circuit device in a semiconductor layer of a first conductivity type, comprising the steps of:
forming a screen insulating layer over said semiconductor layer;
implanting an impurity through said screen insulating layer into said semiconductor layer to form an implanted region;
removing said screen insulating layer; and
annealing said implanted region after removing said screen insulating layer.

2. The method of claim 1 further comprising the step of growing an oxide layer having a thickness in the range of 1-4 nanometers over said implanted region after said step of removing said screen insulating layer.

3. The method of claim 1 or claim 2 in which said step of implanting forms said implanted region adjacent a field oxide region.

4. The method of claim 1, claim 2 or claim 3 in which said step of implanting forms said implanted region adjacent a conductive gate formed over said semiconductor layer.

5. The method of any preceding claim in which said step of removing said screen insulating layer comprises etching said screen insulating layer.

6. The method of any preceding claim in which said step of annealing comprises annealing said implanted region in a furnace in a non-oxidizing atmosphere.

7. The method of any preceding claim further comprising the step of growing a native oxide layer over said implanted region after said step of removing said screen insulating layer.

8. An integrated circuit fromed by the method of any preceding claim.

9. The integrated circuit device of claim 8 in which said semiconductor layer is an epitaxial layer.

10. The integrated circuit device of claim 8 or claim 9 in which said semiconductor layer is formed from p-type material.

11. The integrated circuit device of claim 8, claim 9 or claim 10 in which said semiconductor layer is formed from silicon.

12. The integrated circuit device of any of claims 8 to 11 in which said implanted region is a source/drain region of a field effect transistor.

13. The method of claim 1 in which said implanted region is of a second conductivity type opposite said first conductivity type.

14. An integrated circuit including an integrated circuit device as claimed in any of claims 8 to 12.
